(19) Europäisches Patentamt

European Patent Office

Office européen des brevets

(11) EP 1 122 789 A2

(12) **EUROPEAN PATENT APPLICATION**

(43) Date of publication:
08.08.2001 Bulletin 2001/32

(51) Int Cl.$^7$: H01L 27/146

(21) Application number: 00121862.7

(22) Date of filing: 06.10.2000

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• **Greene, Wayne M.**<br>**Los Gatos, CA 95032 (US)**<br>• **Joseph, Francis**<br>**Sunnyvale, CA 94087-1854 (US)** |
| (30) Priority: **03.02.2000 US 497374** | (74) Representative: **Schoppe, Fritz, Dipl.-Ing. et al**<br>**Schoppe, Zimmermann & Stöckeler**<br>**Patentanwälte** |
| (71) Applicant: **Agilent Technologies Inc.**<br>**a Delaware Corporation**<br>**Palo Alto, CA 94303 (US)** | **Postfach 71 08 67**<br>**81458 München (DE)** |

(54) **Image sensing device that uses photosensitive material for dynamic range extension and control of image sensors**

(57) An image sensing device includes a plurality of photo detectors (20,30,40,51,52,53) and photosensitive material (12,62,64,66) placed over the photo detectors (20,30,40,51,52,53). A transmission coefficient of the photosensitive material (12,62,64,66) is inversely proportional to a rate of photons (16,56) incident on the photosensitive material (12,62,64,66).

FIGURE 1

## Description

### BACKGROUND

The present invention concerns photo sensitive devices and pertains particularly to an image sensor device that uses photosensitive material for dynamic range extension and control of image sensors.

An image sensor device is made up of a linear array or area array of photon-to-electron converters. Currently there are two predominant types of photon-to-electron converters. These are charged coupled devices (CCDs) and complementary metal oxide semiconductor (CMOS) image sensors.

There are several configurations for the CMOS image sensor pixels. A three transistor CMOS sensor configuration uses three transistors. In this configuration, there is a p-n junction photo diode, which is connected to a reset transistor and a source follower transistor. A row-select transistor, when selected, will provide the output of the photo diode to an output rail.

During the normal operation of a CCD or CMOS image sensor, the photodiode will be reset by applying a reset voltage to the reset transistor for a short duration. This procedure will deplete the photo diode of all charges. After the reset, the image to be captured will be integrated for the desired duration. During the integration period, photons falling on the pixel will be converted to electron-hole pairs which in turn will be converted to voltage. The voltage (V) across the photo diode is governed by Equation 1 below:

Equation 1

$$V = Q/C$$

Where:

$$Q = Q_{ph} + Q_{parasitic}$$

$$Q_{ph} = QE * N_{ph}$$

In Equation 1, C is the capacitance of the photo diode. Q is the collected charge. During integration, $Q_{ph}$ is the amount of charge collected in the photo diode and $Q_{parasitic}$ is the parasitic charge generated. QE is the quantum efficiency of the photo diode. $N_{ph}$ is the number of photons.

Image sensors are used in a multitude of applications. In typical applications, photo-sensors are used in a linear array format or an area array format. Linear array and area array sensors are formed by connecting individual photo-sensors. Each of the individual photo-sensors is known as a pixel. Information about an image is reconstructed from the amount of charge generated by photon-to-electron-hole pair conversion on these individual photo-sensors in an array. After integrating the photo diode for a certain amount of time, the value of the voltage in each of these pixels is read out and then the corresponding image is re-constructed using any of the variety of image processing algorithms.

A picture of a scene is very likely to contain areas of a wide range of brightness in the scene. This range of brightness, otherwise known as 'dynamic range of a scene' can become quite prominent when a picture is taken in bright sunlight or taken in a room lit with a few point sources of light. For pixels in areas where the light intensity (or number of photons/area-seconds) is very large, it will take a minimum amount of time to fill up the photo diode wells. For pixels in areas where the light intensity is very small (i.e., dark regions), it will take an enormous amount of time, relative to the bright pixels, to receive enough photons to provide reasonable information. When compensation is made by adjusting the exposure for the bright area, i.e., by having low exposure time, then almost all of the information in the dark area is lost. On the other hand, when the exposure is adjusted to provide a longer exposure time for the dark area, then all of the information in the bright area will be lost (the bright area will appear as if it is flat white).

### SUMMARY OF THE INVENTION

In accordance with the preferred embodiment of the present invention, an image sensing device includes a plurality of photo detectors and photosensitive material placed over the photo detectors. A transmission coefficient of the photosensitive material is inversely proportional to a rate of photons incident on the photosensitive material.

In a preferred embodiment of the present invention, there is a threshold in the rate of photons incident on the photosensitive material above which the photosensitive material restricts a flow of photons to the plurality of photo diodes. Also, in some embodiments of the present invention, the transmission coefficient of the photosensitive material is controlled by an electric field.

The photosensitive material can consist of a single continuous layer. In some embodiments of the invention, color filtering material is deposited over the photosensitive material. Alternatively, the photosensitive material can consist of photosensitive material sections so that a photosensitive material section is placed over each individual photo detector in the plurality of photo detectors. Color filtering material sections can be deposited over each photosensitive material section.

Sensor circuits are used as part of the detection process. Each sensor circuit is connected to a photo detector. For example, each sensor circuit includes three transistors arranged in a sensor configuration. Each photo detector is formed, for example, using a p-n junction. Alternatively, each sensor circuit can include any number of transistors, as allowed by the process technology and geometry of the image sensor, connected to form processing and/or storage of the image data as desired. The photo detector could also include some other light detecting structure such as a p-i-n junction diode.

The advantage of using photosensitive material, as described above, in CCD and CMOS image sensors is that the dynamic range of detected light can be extended far beyond what is possible without use of the photosensitive material. For instance, if a scene being detected by an image sensor has very bright areas and very dark areas, the photosensitive material will restrict the amount of photons collected on the photo diodes used in detecting light from the brighter areas to a desired level. At the same time, almost all of the photons from the darker areas will pass through the photosensitive material and be collected on the photo diodes used in detecting light from the darker areas. This will result in a picture where the details in both the brighter and darker areas are preserved.

BRIEF DESCRIPTION OF THE DRAWINGS

Figure 1 is simplified block diagram that shows an image sensor device that uses photosensitive material for dynamic range extension and control in accordance with the preferred embodiment of the present invention.

Figure 2 is simplified block diagram that shows photosensitive material deposited on photo diodes in accordance with an alternate preferred embodiment of the present invention.

DESCRIPTION OF THE PREFERRED EMBODIMENT

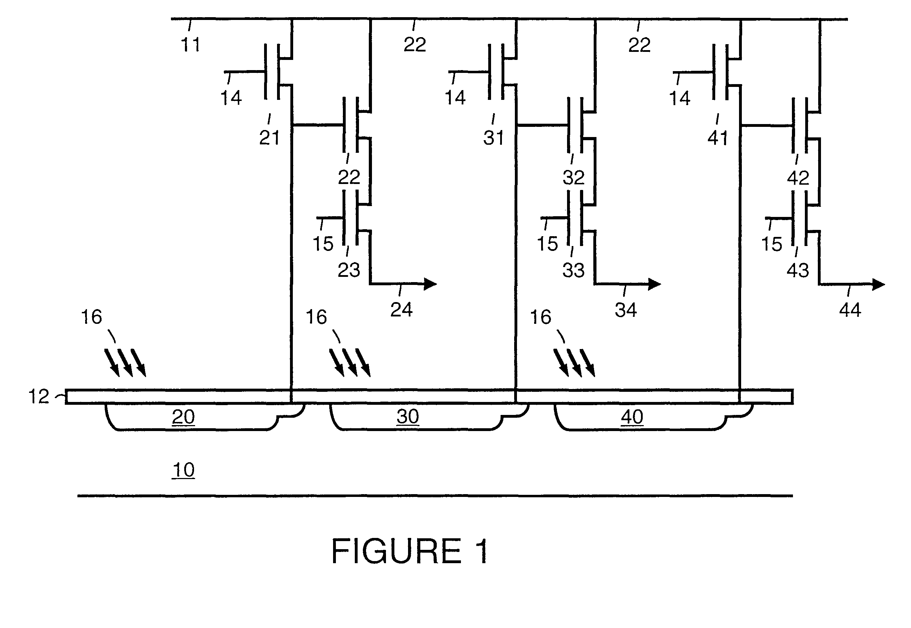

Figure 1 is simplified block diagram that shows an image sensor device that uses photosensitive material 12 for dynamic range extension and control. Photo sensitive material 12 is placed over the photo diodes of the image sensor device. For example, the junction between n+ region 20 and p region 10 forms a first photo diode. The junction between n+ region 30 and p region 10 forms a second photo diode. The junction between n+ region 40 and p region 10 forms a third photo diode. These three photo diodes are merely representative of a linear array or area array of photon-to-electron converters. The photon-to-electron converters in Figure 1 are shown to be photo diodes implemented using complementary metal oxide semiconductor (CMOS) technology. Alternately, as is well understood in the art, photo-to-electron converters could be constructed using charged coupled devices (CCDs) or another technology that facilitates photo detection.

In Figure 1, a three transistor CMOS sensor configuration is shown connected to each photo diode. For the first photo diode, n+ region 20 is connected to a transistor 21 controlled by a reset line 14. Also, n+ region 20 is connected to a transistor that which operates as a source follower transistor. A transistor 23 is controlled by a row selection line 15. Transistor 23, when selected, provides the output of the first photo diode to an output rail 24.

For the second photo diode, n+ region 30 is connected to a transistor 31 controlled by reset line 14. Also, n+ region 30 is connected to a transistor 32 that operates as a source follower transistor. A transistor 33 is controlled by row selection line 15. Transistor 33, when selected, provides the output of the first photo diode to an output rail 34.

For the third photo diode, n+ region 40 is connected to a transistor 41 controlled by reset line 14. Also, n+ region 40 is connected to a transistor 42 which operates as a source follower transistor. A transistor 43 is controlled by row selection line 15. Transistor 43, when selected, provides the output of the first photo diode to an output rail 44.

Arrows 16 represent photons that travel towards n+ region 20, n+ region 30 and n+ region 40. Photosensitive material 12, deposited on top of the photo diodes, controls the number of photons that fall on each of the photo diodes.

The transmission coefficient of photosensitive material 12 is inversely proportional to the rate of photons incident on photosensitive material 12. Additionally, there is a threshold in intensity of the incident light above which photosensitive material 12 will restrict the flow of photons to the photo diodes. Also, the photon transmission property of photosensitive material 12 can be controlled by applying an electric field at the pixel level or for the entire photo diode array. For example, photosensitive material 12 is composed of ($^{***}$What is lone or more] an example of a material?$^{***}$) or some other photosensitive material that satisfies the above described criteria.

For the three photo diodes shown in Figure 1, the change in voltage across the terminals of the photo diode is as set out in Equation 2 below:

<u>Equation 2</u>

$$V = Q/C$$

Where:

$$Q = Qph + Qparasitic$$

$$Qph = Tr\ ^{*}\ QE\ ^{*}\ Nph$$

In Equation 2, C is the capacitance of the photo diode. Q is the collected charge. During integration, Qph is the amount of charge collected in the photo diode and Qparasitic is the parasitic charge generated. QE is the quantum efficiency of the photo diode. Nph is the number (i.e., rate of incidence) of photons falling towards the photo diode. Tr is the transmission coefficient of photosensitive material 12.

In Equation 3 below, the transmission coefficient (Tr) of photosensitive material 12 is specified as a function of the voltage (V) applied to photosensitive material 12 and inversely proportional to the rate of incidence (Nph) of the photons on photosensitive material 12.

Equation 3

$$Tr = f(V, 1/Nph)$$

In the absence of any voltage applied to photosensitive material 12, the transmission coefficient (Tr) is an inverse function of the rate of incidence (Nph) of the photons on photosensitive material 12, as indicated in Equation 4 below:

Equation 4

$$Tr = f(1/Nph)$$

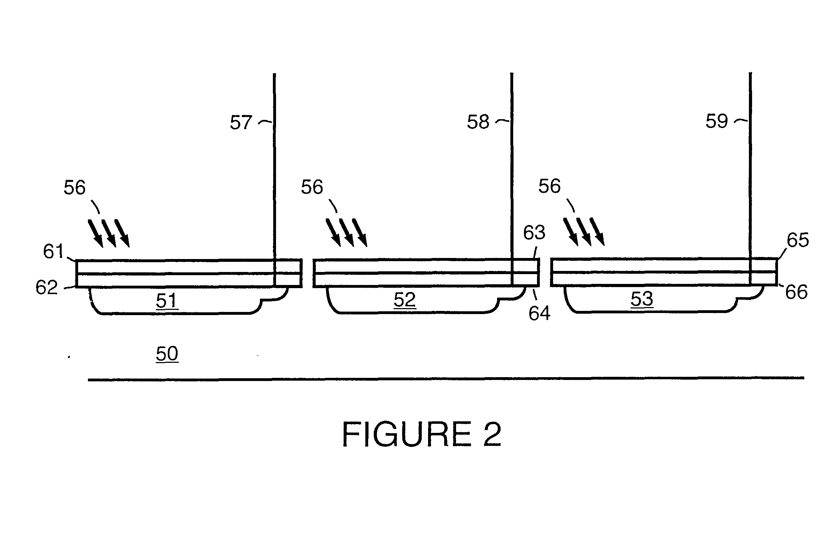

Figure 2 shows an alternative embodiment of the present invention. In Figure 2, the junction between n+ region 51 and p region 50 forms a first photo diode. The junction between n+ region 52 and p region 50 forms a second photo diode. The junction between n+ region 53 and p region 50 forms a third photo diode. These three photo diodes are merely representative of a linear array or area array of photon-to-electron converters. The photon-to-electron converters in Figure 2 are shown to be photo diodes implemented using complementary metal oxide semiconductor (CMOS) technology. Alternately, as is well understood in the art, photo-to-electron converters could be constructed using charged coupled devices (CCDs) or another technology that facilitates photo detection. Arrows 56 represent photons that travel towards n+ region 51, n+ region 52 and n+ region 53.

A connection line 57 is used to connect n+ region 51 to a sensor circuit, such as the three transistor sensor configuration shown in Figure 1. A connection line 58 is used to connect n+ region 52 to a sensor circuit. A connection line 59 is used to connect n+ region 53 to a sensor circuit.

In the embodiment shown in Figure 2, photosensitive material sections are formed on top of the image sensor on a pixel by pixel basis. For example, photosensitive material 62 is shown formed on top of n+ region 51. Photosensitive material 64 is shown formed on top of n+ region 52. Photosensitive material 66 is shown formed on top of n+ region 53. Electrically isolating photosensitive material 62 from photosensitive material 64 and photosensitive material 66, allows different strength electric fields to be placed on the photosensitive material on a pixel by pixel basis.

In the embodiment shown in Figure 2, photosensitive material is combined with color filters. The color filters selectively pass the desired wavelength(s) through to the photosensitive material and control the number of photons passing through to the photosensitive material. For example, in Figure 2, color filter material 61 is deposited on photosensitive material 62. Color filter material 63 is deposited on photosensitive material 64. Color filter material 65 is deposited on photosensitive material 66. C

The foregoing discussion discloses and describes merely exemplary methods and embodiments of the present invention. As will be understood by those familiar with the art, the invention may be embodied in other specific forms without departing from the spirit or essential characteristics thereof. Accordingly, the disclosure of the present invention is intended to be illustrative, but not limiting, of the scope of the invention, which is set forth in the following claims.

**Claims**

1. An image sensing device comprising:

   a plurality of photo detectors (20,30,40,51,52,53); and,
   photosensitive material (12,62,64,66) placed over the photo detectors (20,30,40,51,52,53), wherein a transmission coefficient of the photosensitive material (12,62,64,66) is inversely proportional to a rate of photons (16,56) incident on the photosensitive material (12,62,64,66).

2. An image sensing device as in claim 1 wherein there is a threshold in the rate of photons (16,56) incident on the photosensitive material (12,62,64,66) above which the photosensitive material (12,62,64,66) restricts a flow of photons (16,56) to the plurality of photo detectors (20,30,40,51,52,53).

3. An image sensing device as in claim 1 wherein the transmission coefficient of the photosensitive material (12,62,64,66) is controlled by an electric field.

4. An image sensing device as in claim 1 wherein the photosensitive material (12) consists of a single continuous layer.

5. An image sensing device as in claim 1 wherein the photosensitive material (62,64,66) consists of photosensitive material sections (62,64,66) so that a photosensitive material (62,64,66) section is placed over each individual photo detector in the plurality of photo detectors (51,52,53).

6. An image sensing device as in one of claims 1 to 5 wherein the photosensitive material consists of photosensitive material sections (62, 64, 66) so that a photosensitive material section is placed over each individual photo detector (51, 52, 53) in the plurality of photo detectors and wherein color filtering material (61, 63, 65) is deposited over each photosensitive material section (62, 64, 66).

7. An image sensing device as in any preceeding claim wherein color filtering material (61,63,65) is deposited over the photosensitive material (62,64,66).

8. A method for sensing an image comprising:

   (a) detecting an incident rate of photons (16,56) on each of a plurality of photo detectors (20,30,40,51,52,53); and,
   (b) reducing the incident rate of photons (16,56) on each of the plurality of photo detectors (20,30,40,51,52,53) by filtering photos using photosensitive material (12,62,64,66) placed over the photo detectors (20,30,40,51,52,53), wherein a transmission coefficient of the photosensitive material (12,62,64,66) is inversely proportional to a rate of photons (16,56) incident on the photosensitive material (12,62,64,66).

9. A method as in claim 8 wherein in step (b) there is a threshold in the rate of photons (16,56) incident on the photosensitive material (12,62,64,66) above which the photosensitive material (12,62,64,66) restricts a flow of photons (16,56) to the plurality of photo detectors (20,30,40,51,52,53).

10. A method as in claim 8 wherein in step (b) the transmission coefficient of the photosensitive material (12,62,64,66) is controlled by an electric field.

FIGURE 1

FIGURE 2

EP 1 122 789 A2